# NEUE EUROPÄISCHE PATENTSCHRIFT

(11) **EP 1 577 165 B2**
(45) Veröffentlichungstag und Bekanntmachung des Hinweises auf die Entscheidung über den Einspruch: **09.08.2017**
(45) Hinweis auf die Patenterteilung: 16.05.2007
(21) Anmeldenummer: 04101058.8
(22) Anmeldetag: 15.03.2004
(51) Int. Cl.: B60R 13/02

(54) **Kraftfahrzeug-Innenverkleidungsteil mit Metallstruktur**
Vehicle interior trimming with metallic structure
Elément d'habillage intérieur de véhicule pourvu d'une structure métallique

(43) Veröffentlichungstag der Anmeldung: 21.09.2005
(73) Patentinhaber: NOVEM Car Interior Design Metalltechnologie GmbH, 95519 Vorbach (DE)
(72) Erfinder: Wilfert, Michael, 95490 Mistelgau (DE); Fick, Rainer, 95466 Weidenberg (DE); Weiskopf, Wolfram, 95517 Emtmannsberg (DE)
(74) Vertreter: Szynka, Dirk

(56) Entgegenhaltungen:
- EP-A2- 1 219 401
- AT-B- 228 994
- DD-A5- 111 845
- DE-A1- 4 132 413
- DE-A1- 4 441 986
- DE-A1- 10 126 703
- DE-A1- 19 522 480
- DE-A1- 19 713 949
- DE-A1- 19 732 425
- DE-A1- 19 801 985
- DE-A1- 19 948 664
- DE-B- 1 271 972
- DE-C1- 19 546 551
- DE-C2- 19 914 092
- DE-T2- 698 004 676
- DE-U1- 9 321 214
- DE-U1- 20 306 670
- GB-A- 589 260
- JP-A- H06 278 162
- JP-A- H10 128 921
- US-A- 4 128 683
- PATENT ABSTRACTS OF JAPAN Bd. 0174, Nr. 33 (M-1461), 11. August 1993 (1993-08-11) & JP 5 096680 A (HONDA MOTOR CO LTD), 20. April 1993 (1993-04-20)
- PATENT ABSTRACTS OF JAPAN Bd. 0112, Nr. 28 (M-610), 24. Juli 1987 (1987-07-24) & JP 62 043336 A (KANAI JIYUUYOU KOGYO KK; others: 02), 25. Februar 1987 (1987-02-25)

## Beschreibung

Die vorliegende Erfindung betrifft ein Verfahren zur Herstellung eines Kraftfahrzeug-Innenverkleidungsteils und das Innenverkleidungsteil selbst.

Es ist bekannt, in Kraftfahrzeugen Innenverkleidungsteile mit verschiedenen dekorativen Oberflächen einzusetzen. Bei solchen Innenverkleidungsteilen werden Materialoberflächen eingesetzt, die neben den eher funktionellen Gesichtspunkten der Lichtechtheit, Medienbeständigkeit, Abwaschbarkeit und dgl. auch besonderen ästhetischen Ansprüchen genügen müssen. Besonders weit verbreitet sind Innenverkleidungsteile mit Aluminiumoberflächen und Holzoberflächen oder Holzimitatoberflächen. Ein solches Innenverkleidungsteil wird in Dokument GB-A-589260 offenbart.

Es ist ferner bekannt, solche Innenverkleidungsteile in einer Mehrzahl von miteinander verbundenen Schichten herzustellen. In der Regel werden auf eine Trägerstruktur aus Metall oder Kunststoff, die im eingebauten Zustand auf der dem Innenraum des Kfz abgewandten Seite angeordnet ist und besonders ausgeformte Strukturelemente zur Befestigung aufweist, weitere Schichten aufgebracht. Insbesondere können Holz- oder Aluminiumschichten aufgeklebt sein. Diese können von weiteren Schutzschichten, beispielsweise Lackschichten, überzogen sein.

Der Erfindung liegt das Problem zugrunde, den Gestaltungsspielraum bei Kfz-Innenverkleidungsteilen zu erhöhen.

Die Erfindung richtet sich auf ein Verfahren nach Anspruch 1.

Bevorzugte Ausgestaltungen sind in den abhängigen Ansprüchen angegeben. Dabei und in der folgenden Beschreibung wird nicht mehr streng zwischen Verfahrensmerkmalen und Produktmerkmalen des Innenverkleidungsteils unterschieden. Vielmehr beziehen sich die Einzelheiten auf beide Kategorien.

Die Erfindung geht davon aus, dass sich bei Innenverkleidungsteilen die ästhetische Wirkung durch Strukturierung von Metalloberflächen deutlich steigern lässt. Bei dem erfindungsgemäßen Verfahren und Innenverkleidungsteil werden also Metallstrukturen eingesetzt, die komplizierter als ein einfaches flächiges Metallblech ausgebildet sind. Vielmehr sind Metallstrukturen gemeint, die in irgendeiner Weise zumindest senkrecht zu ihrer flächigen Erstreckung durchlässig sind, d. h. Fluide hindurchlassen. Beispiele sind Drahtstrukturen, insbesondere Drahtgewebe, Streckmetallstrukturen oder auch andere, beispielsweise durch Stanzen oder andere Techniken perforierte Metallstrukturen.

Solche Metallstrukturen können einen erheblichen ästhetischen Reiz bieten, wobei sich die Erfindung auch auf solche Fälle bezieht, in denen die metallische Oberfläche der Metallstruktur selbst nicht mehr sichtbar ist, beispielsweise weil sie lackiert oder in anderer Weise nicht transparent beschichtet ist.

Bei solchen durchlässigen Metallstrukturen soll erfindungsgemäß durch eine Sperrschicht verhindert werden, dass während der Herstellung Material anderer Schichten, das zumindest in bestimmten Phasen der Herstellung fließfähig (einschl. zähflüssig, etwa bei Expansion) ist, unkontrolliert durch die Metallstruktur hindurchtritt. Je nach Ausgestaltung der Erfindung kann die Sperrschicht dabei durchaus zulassen, dass solches Material in die Metallstruktur eindringt. Auf diesen Aspekt wird noch näher eingegangen.

Erfindungsgemäß ist vorgesehen, dass die Metallstruktur etwas durchsichtig ist, also eine darunter liegende Schicht zu sehen ist. Dabei kann es sich insbesondere um eine darunter liegende Holzschicht oder Metallschicht handeln. Insbesondere kann die Sperrschicht auch als Haftvermittlungsschicht zwischen einer Dekorschicht, etwa aus Holz oder Aluminium, und der Metallstruktur dienen. Die Sperrschicht kann dabei so gestaltet sein, dass sie wegen der Materialstärke und wegen geringer Färbung oder Farblosigkeit optisch praktisch nicht in Erscheinung tritt. Weiter unten wird noch einmal näher erläutert, dass es bei besonderen Ausgestaltungen der Erfindung auch dazu kommen kann, dass eine solche Holz- oder Metallschicht die Funktion der Sperrschicht selbst ausübt.

Ferner ist bevorzugt, dass eine Trägerstruktur des Innenverkleidungsteils an den Verbund aus der Metallstruktur und der Sperrschicht und evtl. weiterer Schichten angegossen oder angespritzt wird. Besonders relevant ist dabei der Fall, in dem die Sperrschicht dazu dient, ein Eindringen des während des Angießens oder Anspritzens fließfähigen Trägerstrukturmaterials, insbesondere eines Thermoplasten, in die Metallstruktur zu verhindern. In diesem Fall ist die Sperrschicht also auf der gleichen Seite der Metallstruktur angeordnet wie die Trägerstruktur.

Die Sperrschicht kann so mit der Metallstruktur verbunden werden, dass sie lediglich daran haftet. Bevorzugt in Betracht kommen jedoch solche Fälle, in denen die Sperrschicht durch ein zumindest teilweises Erweichen zumindest teilweise in die Metallstruktur hineingedrückt wird und sich damit besonders gut mit der Metallstruktur verbindet. Bevorzugtes Material für die Sperrschicht ist Polyamidfolie. Die Metallstruktur kann selbstverständlich in verschiedener Weise vorbehandelt sein, um eine gute Haftung sicherzustellen. In Betracht kommen Lackierungen, Chromatierungen, Konversionsbehandlungen und dgl.

Die Verbindung zwischen der Sperrschicht und einer darunter liegenden Schicht, insbesondere einer Trägerstruktur, kann eine reine Klebeverbindung sein, insbesondere über eine Trockenklebefolie. Es kann hier aber auch ein Zweikomponenten-PU-Klebstoff oder eine andere Klebetechnik verwendet werden.

Vorzugsweise wird die Metallstruktur mit der Sperrschicht und der Trägerstruktur, und möglicherweise weiteren Schichten zwischen der Sperrschicht und der Trägerstruktur, in einem einheitlichen Prozessschritt verbunden, insbesondere in einer erwärmten Formschale. Dabei kann die Formschale beim Schließen auch als Schneidwerkzeug verwendet werden. Bei dieser Erfindung ist jedoch bevorzugt, dies allenfalls für zum Zentrieren der entsprechenden Schichten in der Formschale verwendete Zentrierlaschen vorzusehen und die Schichten im Übrigen endformnah zuzuschneiden, so dass sie bereits beim Einlegen in die Formschale passen.

Eine Variante der Erfindung sieht vor, eine Trägerstruktur auf der der Sperrschicht entgegengesetzten Seite der Metallstruktur anzuspritzen oder anzugießen. In diesem Fall wird, da die Sperrschicht gewöhnlich die Metallstruktur nicht völlig durchdringt, das Trägerstrukturmaterial relativ weit in die Metallstruktur eindringen oder diese sogar fast durchdringen. Die Sperrschicht kann in einem späteren Arbeitsgang abgelöst werden, womit die Metallstruktur auf dem Trägerstrukturmaterial je nach Wunsch fast vollständig oder nur mit den über das Trägerstrukturmaterial hinausragenden Teilen sichtbar ist.

Bei dieser Vorgehensweise muss also die Sperrschicht mit der Metallstruktur verbunden werden. In vielen Fällen wird ein Vorformen notwendig sein, woraufhin der Anspritz- oder Angießvorgang erfolgen kann. Bevorzugt ist, dass die Schritte des Verbindens der Sperrschicht mit der Metallstruktur und des Vorformens in einem einheitlichen Prozessschritt in einem beheizten Werkzeug, ähnlich wie die erwähnte Formschale, erfolgen. Alternativ dazu kann aber die Sperrschicht beispielsweise warm auf die Metallstruktur aufgewalzt werden oder eine Verbindung von Sperrschicht und Metallstruktur jeweils als Plattenware erfolgen.

In Ausgestaltung dieses Erfindungsaspekts ist es möglich, den Verbund aus Metallstruktur und Sperrschicht beidseits mit einer angespritzten oder angegossenen Schicht zu versehen, wobei eine Seite transparent ist und die andere Seite als Träger dient oder auf dem Träger montiert wird. Zunächst wird dabei auf der der Sperrschicht entgegengesetzten Seite der Metallstruktur angespritzt oder angegossen, daraufhin die Sperrschicht abgelöst und die damit freigelegte Seite wiederum mit einer weiteren Schicht versehen. Insbesondere kann es sich bei der transparenten Schicht um eine angegossene Schicht handeln und bei der anderen Schicht um eine angespritzte Trägerstruktur. Vorzugsweise wird dabei zuerst angespritzt und nach dem Ablösen der Sperrschicht vergossen.

Eine weitere Ausgestaltung sieht vor, auf einer teiltransparenten Metallstruktur eine Holzschicht, Aluminiumschicht oder andere Dekorschicht als Sperrschicht aufzubringen und dann die entgegengesetzte Seite mit einer angespritzten oder angegossenen transparenten Schicht zu versehen. Hierbei kann die transparente Schicht, die die Metallstruktur durchdringt und bis zu der Dekorschicht vordringt, als Haftvermittlung zwischen der Dekorschicht und der Metallstruktur dienen. Bei diesem Beispiel dient also die Sperrschicht lediglich dazu, ein unkontrolliertes Durchdringen der Metallstruktur durch ein fließfähiges Schichtmaterial zu verhindern, wobei jedoch die transparente Schicht die Metallstruktur praktisch vollständig einnimmt.

Die Dekorschicht kann ihrerseits bereits Trägerstruktur sein oder mit einer Trägerstruktur verbunden sein oder werden.

Wenn in der vorstehenden Beschreibung von Schichten, insbesondere von der Metallstruktur und der Sperrschicht, die Rede ist, so bedeutet dies nicht notwendigerweise, dass sich diese über die gesamte Fläche des Innenverkleidungsteils erstrecken. Es können auch interessante Dekoreffekte erzielt werden, wenn beispielsweise die Metallstruktur nur einen Teil der Fläche einnimmt oder wenn die Sperrschicht nur einen Teil der Fläche einnimmt und die Metallstruktur im Übrigen von einem anderen Schichtmetall durchdrungen ist. Auch damit kann erreicht werden, dass die Metallstruktur nur teilweise sichtbar ist.

Im Folgenden werden Ausführungsbeispiele für die Erfindung erläutert. Die Einzelmerkmale können auch in anderen Kombinationen erfindungswesentlich sein. Auch die folgende Beschreibung bezieht sich sowohl auf den Vorrichtungscharakter als auch den Verfahrenscharakter der Erfindung.

Es zeigen:
- Figuren 1-3: schematische Schnittansichten durch ein Formschalenwerkzeug bei der erfindungsgemäßen Herstellung eines Innenverkleidungsteils.
- Figuren 4-10: schematische Schnittansichten zur Illustration weiterer Ausführungsbeispiele.

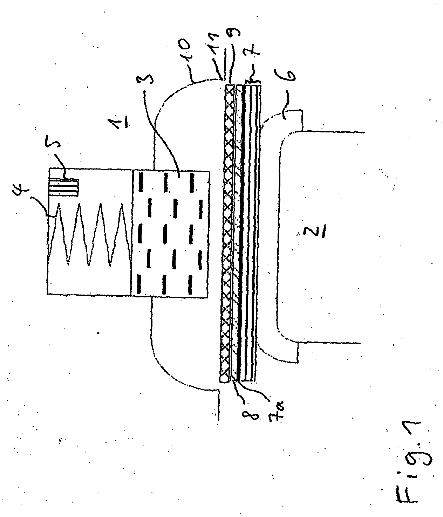

Figur 1 zeigt ein beheizbares Formschalenwerkzeug zur Herstellung eines erfindungsgemäßen Innenverkleidungsteils. Das Formschalenwerkzeug weist ein Oberteil (Matrize) 1 und ein Unterteil (Stempel) 2 mit jeweiligen Formschalenflächen auf, wobei das Oberteil 1 vertikal auf das Unterteil 2 hinunterbewegt werden kann. In dem Oberteil 1 ist ein Voreiler, d. h. ein vertikal verschiebbar gelagerter Bolzen 3 angebracht. Der Voreiler 3 ist nach Figur 1 über eine Feder 4 vertikal kraftbeaufschlagt. Diese Feder 4 kann tatsächlich auch beispielsweise als Druckfluidzylinder ausgeführt sein, etwa um gewünschte nicht lineare Kraftverlaufskennlinien zu realisieren.

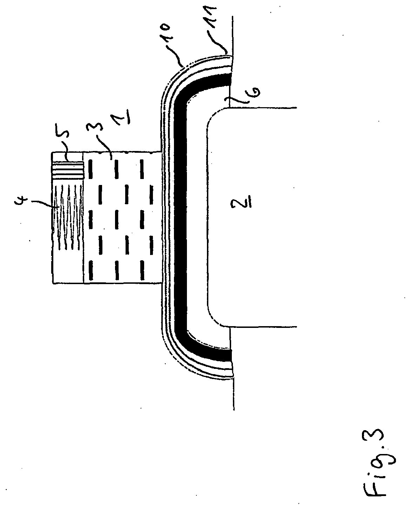

Ferner ist ein Anschlag 5 vorgesehen, der den Weg des Voreilers 3 nach oben begrenzt. Wie anhand Figur 3 noch deutlicher wird, erfolgt dies in solcher Weise, dass dann die untere Fläche des Voreilers 3 bündig mit der Formschalenfläche des Oberteils 1 abschließt.

Auf das Unterteil 2 ist bei diesem Ausführungsbeispiel ein gebogenes Blechteil 6 als Trägerstruktur aufgelegt. Bei diesem Ausführungsbeispiel ist das Blechteil 6 vorgebogen, weil es mit besonderen Befestigungselementen versehen wird, die sich nicht in einem einheitlichen Formschritt mit den Schichten 7, 8 und 9 herstellen lassen und einem Biegen des Blechteils 6 zusammen mit diesen Schichten entgegenstehen.

Auf der Blechträgerstruktur 6 liegt flächig ein Schichtaufbau 7 aus Holzlaminatschichten auf, der auf sich eine Sperrschicht 8 in Form einer Polyamid-Kaschierfolie trägt. Auf der Sperrschicht 8 wiederum liegt ein Drahtgewebe 9 als erfindungsgemäße Metallstruktur.

Im Übrigen sind die Schichten 7, 8 und 9 fertig beschnitten und passen damit in die Formschale und zu der gewünschten Geometrie des Innenverkleidungsteils. Lediglich die erwähnten Zentrierlaschen können durch die Quetschkante 11 abgequetscht werden.

In ihrem Randbereich ist die Formschalenfläche des Oberteils 1 mit einer Abstellung und einer Quetschkante versehen. Die Abstellung ist mit 10 und die Quetschkante mit 11 bezeichnet.

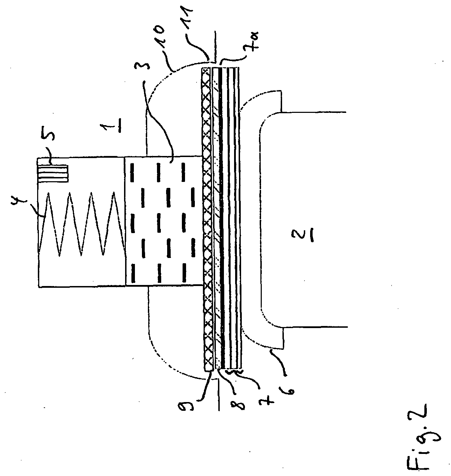

Die Figuren 2 und 3 zeigen dieselbe Prinzipdarstellung des Formschalenwerkzeugs, wobei in Figur 2 das Oberteil 1 soweit abgesenkt wurde, dass der Voreiler 3 auf der Metallstruktur 9 aufsitzt und diese durch Kraftbeaufschlagung durch die Feder 4 bzw. einen Druckfluidzylinder an deren Stelle festhält. Dazu kann die untere Fläche des Voreilers 3, die mit der Metallstruktur 9 in Kontakt kommt, etwas angeraut sein, solange sich keine die Dekorfunktion beeinflussenden Abdrücke auf der Metallstruktur ergeben.

In der Phase von Figur 1 zu Figur 2 werden die Schichten 7, 8 und 9 durch übliche Zentrierstifte des Formschalenwerkzeugs gehalten, die in entsprechenden Zentrierlaschen der Schichten 7, 8 und 9 eingreifen, hier jedoch nicht gezeichnet sind.

Figur 3 zeigt einen weiteren Schritt, in dem das Oberteil 1 soweit auf das Unterteil 2 abgesenkt wurde, dass die Schichten 7, 8 und 9 auf die Form der Trägerstruktur 6 bzw. des Unterteils 2 aufgepresst und miteinander durch Druck und eine Umformtemperatur von etwa 160 °C verpresst werden. Zwischen der Sperrschicht 8 und dem Holzlaminatschichtaufbau 7 ist dabei eine Trokkenklebefolie 7a vorgesehen. Eine Trockenklebefolie ist auch zwischen dem Holzlaminatschichtaufbau 7 und der Trägerstruktur 6 vorgesehen, jedoch nicht eingezeichnet. Der Holzlaminatschichtaufbau 7 kann ferner zur Verbesserung der Klebeigenschaften vorbehandelt sein. Sowohl die Sperrschicht 8 als auch die Trockenklebefolie 7a sind dabei so ausgewählt, dass sie optisch kaum in Erscheinung treten und die dekorative Wirkung des Holzdekors des Aufbaus 7 nicht beeinträchtigen.

Der Konturverlauf der Abstellung 10 mit der Quetschkante 11 dient, was Figur 3 nicht im Einzelnen darstellt, dazu, den Aufbau in diesem Bereich besonders stark zu verpressen und die Metallstruktur 9 in die Sperrschicht 8 einzupressen. Andererseits muss bei der Geometrie darauf geachtet werden, dass insgesamt eine Entformschräge von 3° eingehalten wird. Die Quetschkante 11 ist also in geringem Umfang nach innen angeschrägt, und zwar nur in solchem Maß, dass das fertige Innenverkleidungsteil wieder aus dem Formschalenoberteil 1 entnommen werden kann. Der von dieser Verpressung betroffene Randbereich des Innenverkleidungsteils ist im eingebauten Zustand im Kraftfahrzeug nicht mehr sichtbar.

Die Umformung erfolgt hauptsächlich durch Biegen (statt Tiefziehen), um einen Gewebeverzug in der Metallstruktur 9 zu vermeiden und die Maschenöffnungen gleichmäßig zu halten.

Wenn nach ausreichender Zeit das Formschalenwerkzeug wieder geöffnet worden ist, so kann das fertige Innenverkleidungsteil entnommen werden. Dieses zeigt eine ästhetisch ansprechende Metallstrukturoberfläche 9, durch die hindurch durch die im Wesentlichen transparente Kaschierfolien-Sperrschicht 8 und Trockenklebefolie auch das Holzdekor des Holzlaminataufbaus 7 zu sehen ist. Als Varianten kommen beispielsweise Edelstahl- oder Aluminium-Drahtgewebe in offener oder auch blickdichter Ausführung oder Edelstahl- oder Aluminium-Streckmetallstrukturen in Betracht, derer Oberflächen anodisiert, gefärbt oder lackiert sein können.

Die Polyamid-Kaschierfolie dient nicht nur als Sperrschicht, um ein Eindringen des Trockenklebefilms in die Metallstruktur und damit eine optische Beeinträchtigung zu verhindern. Die Polyamid-Kaschierfolie bietet darüber hinaus eine Haftvermittlung durch gute Klebeeigenschaften einerseits und anderseits eine gute Haftung und zusätzlich mechanische Verkrallung nach der Verpressung mit der Metallstruktur.

Das fertige Designelement kann nach Wunsch nachträglich lackiert werden oder auch mit der (Dekor-) Oberseite transparent eingegossen werden. Es ist ferner sinnvoll, die fertige Dekoroberfläche mit einer Schutzfolie zu versehen, um beim Transport und Einbau in dem Kraftfahrzeug Schäden zu vermeiden. Dabei kann diese Schutzfolie auch bereits in das in den Figuren 1 - 3 dargestellten Formschalenwerkzeug eingebracht werden.

Die Sperrschicht 8 kann in Einzelfällen auch als Designelement sichtbar sein. Die Einpresstiefe wird neben den geometrischen Details der Metallstruktur 9 durch die Foliendicke der Polyamidfolie 8, den Druck und die Distanz von Werkzeugoberteil 1 und -unterteil 2 und die Temperatur bestimmt.

Die Nachbehandlung kann ein Kantenschleifen, eine Versiegelung durch beispielsweise ein angeklebtes Filz (auch zum akustischen Schutz) und das Aufbringen einer Dichtraupe aus Klebstoff umfassen. Es kann aber auch der Rand umbördelt werden und eine rückseitige Abdeckung angebracht werden, womit das Schleifen entfällt.

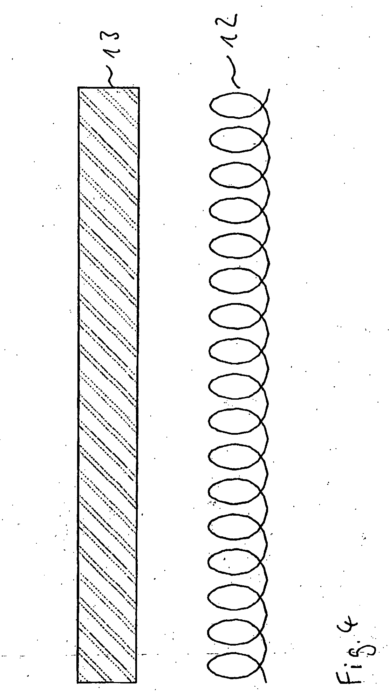

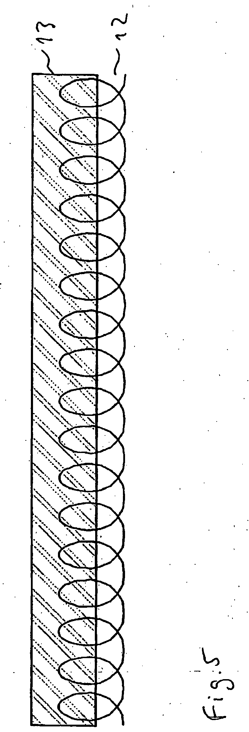

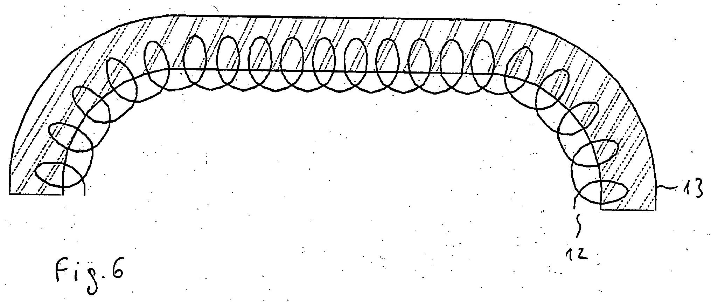

Die Figuren 4 - 8 illustrieren schematisch ein anderes Ausführungsbeispiel. Gemäß Figur 4 wird eine Metallstruktur 12, in diesem Fall ein hier nur symbolisch dargestelltes Drahtgewebe, mit einer Sperrschicht in Form einer Polyamid-Kaschierfolie 13 beschichtet. Dies kann durch Warmaufwalzen unter Abrollen oder in Form von Plattenmaterial geschehen. Dabei dringt die Polyamid-Sperrschicht 13 etwas in die Metallstruktur 12 ein, wie Figur 5 zeigt. Der entsprechende Verbund wird in die gewünschte Form gebracht, wie Figur 6 zeigt. Dies kann in einem ähnlichen Formschalenwerkzeug wie in den Figuren 1 - 3 dargestellt geschehen. Insbesondere kann dabei auch das Verbinden der Schichten 12 und 13 zusammen mit der Formgebung in einem einheitlichen Schritt erfolgen.

Die Verbindung mit der Sperrschicht stabilisiert den Verbund für die Folgeprozesse und ermöglicht darüber hinaus eine Fixierung durch Ansaugen in einem Formschalenwerkzeug ähnlich den Figuren 1 - 3.

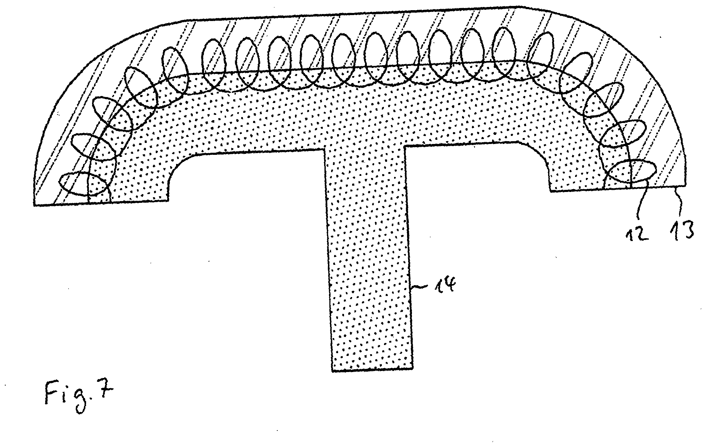

Daraufhin kann auf die freigebliebene Seite der Drahtgewebe-Metallstruktur 12 in an sich bekannter Weise eine thermoplastische Trägerstruktur angespritzt werden, die hier mit 14 bezeichnet ist. Das thermoplastische Material dringt dabei in dem freigebliebenen Bereich in das Drahtgewebe 12 ein. Der in Figur 7 erkennbare Zapfen soll symbolisch ein Formelement darstellen, mit dem das Innenverkleidungsteil im Kfz befestigt werden kann. Entsprechende Formelemente kann natürlich auch das gemäß den Figuren 1- 3 hergestellte Innenverkleidungsteil zeigen.

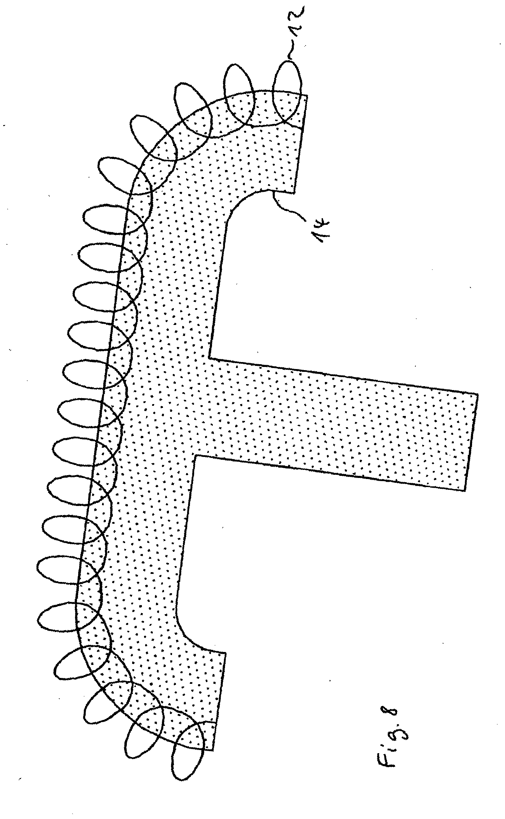

Figur 8 zeigt nun die Struktur aus Figur 7, wobei jedoch die Polyamid-Sperrschicht 13 abgelöst worden ist. Wenn sie sich nicht zu stark mit dem Drahtgewebe verkrallt hat, kann sie einfach abgezogen werden.

Damit ist in einer besonders einfachen Weise ein fertiges Innenverkleidungsteil hergestellt worden, das sich nun in üblicher Weise weiterverarbeiten lässt.

Auf die in Figur 8 dargestellte und wie soeben erläutert hergestellte Struktur lässt sich allerdings auch beispielsweise eine transparente Schicht zum Einbetten des Drahtgewebes 12 aufbringen, insbesondere durch Vergießen. Diese weitere Struktur ist in Figur 8 nicht gezeigt, würde sich jedoch darauf beschränken, das Drahtgewebe 12 transparent einzubetten.

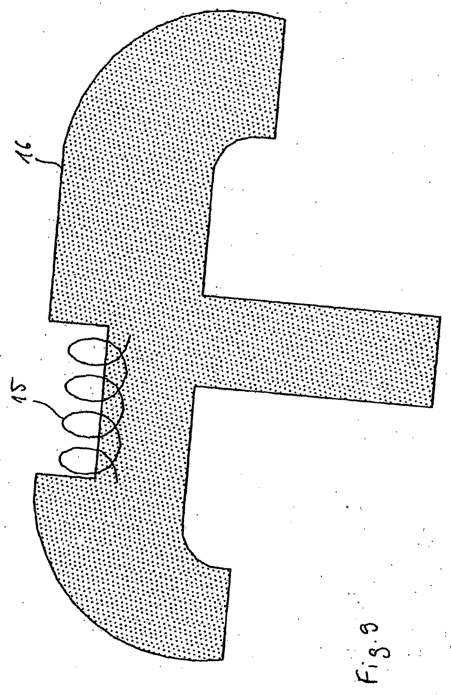

- Figur 9 illustriert symbolisch, dass sich die Metallstruktur, hier mit 15 bezeichnet, nicht notwendigerweise über die gesamte Fläche des Innenverkleidungsteils 16 erstrecken muss. Es kann sich auch um eine dekorative Einlage handeln. Bezug nehmend auf das Beispiel aus den Figuren 4 - 8 wäre auch die Sperrschicht 13 flächig so zu bemessen, wie die Metallstruktur 15. Es ist ferner natürlich auch möglich, wenngleich hier nicht gezeichnet, eine Metallstruktur nur zu einem Teil freizulegen, beispielsweise indem eine Sperrschicht kleiner als die Metallstruktur ist. Ferner kann im Prinzip auch mit unterschiedlichen Eindringtiefen der Sperrschicht in die Metallstruktur gearbeitet werden, und zwar auch in dem gleichen Innenverkleidungsteil an verschiedenen Stellen, wenn sich dadurch gewünschte dekorative Effekte erzielen lassen. Vor allem durch Sperrschichten aus unterschiedlichen Thermoplasten lassen sich unterschiedliche Eindringtiefen und damit unterschiedlich stark freigehaltene Bereiche der Metallstruktur erzielen.

Im Übrigen gelten die Ausführungen zu dem ersten Ausführungsbeispiel, insbesondere in Bezug auf den endformnahen Zuschnitt.

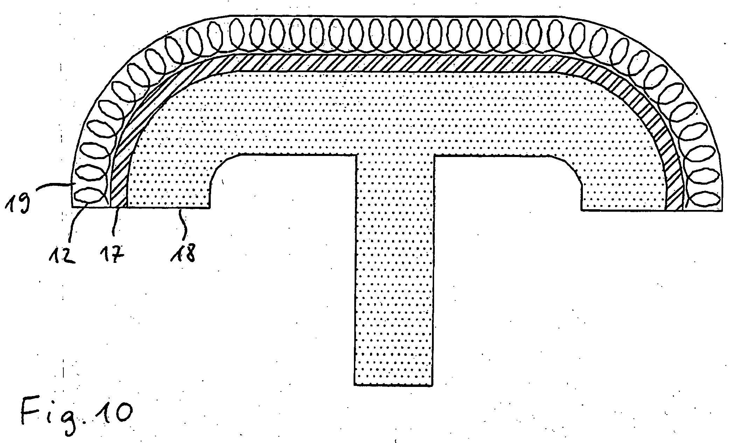

Figur 10 zeigt ein weiteres Ausführungsbeispiel der Erfindung. Hier ist eine Holzschicht 17 als Sperrschicht auf ein Drahtgewebe 12 aufgeklebt worden. Eine Trägerstruktur 18 kann auf die Holzschicht 17 danach oder auch am Ende des Verfahrens angespritzt werden. Auf der der Holzschicht 17 entgegengesetzten Seite des Drahtgewebes 12 ist eine transparente Schicht angegossen worden, die bis zu der als Sperrschicht wirkenden Holzschicht 17 vorgedrungen ist und das Drahtgewebe 12 eingebettet hat. Hier dient also die Holzschicht 17 als Sperrschicht und begrenzt das Durchdringen der transparenten Schicht 19 durch das Drahtgewebe. Die Trägerstruktur 18 kann auch nach dem Aufbringen der transparenten Schicht 19 angespritzt werden.

## Patentansprüche

1. Verfahren zum Herstellen eines Kfz-Innenverkleidungsteils,
bei welchem Verfahren eine flächige Metallstruktur (9, 12, 15), die senkrecht zu ihrer Flächigkeit für Fluide durchlässig ist,
mit einer Sperrschicht (8, 13, 17) verbunden wird
und mit einer weiteren Schicht (7a, 14, 16, 19) verbunden wird,
wobei die Sperrschicht (8, 13, 17) das Durchdringen der weiteren Schicht (7a, 14, 16, 19) durch die Metallstruktur (9, 12, 15) begrenzt,
**dadurch gekennzeichnet, dass** nach der Herstellung des Innenverkleidungsteils die Metallstruktur (9, 12, 15) zumindest teilweise durchsichtig und eine unter der Metallstruktur (9, 12, 15) angeordnete Schicht (7, 14, 16, 17) durch die Metallstruktur (9, 12, 15) hindurch sichtbar ist.

2. Verfahren nach Anspruch 1, bei dem die Metallstruktur (9, 12, 15) eine Drahtstruktur, insbesondere ein Drahtgewebe, ist.

3. Verfahren nach einem der vorstehenden Ansprüche, bei dem die Metallstruktur (9, 12, 15) als solche nach Herstellung des Innenverkleidungsteils zumindest teilweise als Dekorationsbestandteil sichtbar ist.

4. Verfahren nach einem der vorstehenden Ansprüche, bei dem eine Trägerstruktur (14, 16, 18) des Innenverkleidungsteils angespritzt oder angegossen wird.

5. Verfahren nach Anspruch 4, bei dem die Sperrschicht (13) das Durchdringen des Trägerstrukturmaterials (14, 16) durch die Metallstruktur (12, 15) begrenzt.

6. Verfahren nach einem der vorstehenden Ansprüche, bei dem die Verbindung zwischen der Metallstruktur (9, 12, 15) und der Sperrschicht (8, 13) unter Erweichen der Sperrschicht (8, 13) und zumindest teilweise in die Metallstruktur (9, 12, 15) Hineingedrückt werden der Sperrschicht (8, 13) erfolgt.

7. Verfahren nach Anspruch 6, bei dem die Sperrschicht (8, 13) aus einer Polyamidfolie hergestellt wird.

8. Verfahren nach einem der vorstehenden Ansprüche, bei dem die Sperrschicht (8) mit einer weiteren Schicht (7) verklebt wird, vorzugsweise über eine Trockenklebefolie (7a).

9. Verfahren nach einem der vorstehenden Ansprüche, bei dem das Verbinden der Metallstruktur (9) mit der Sperrschicht (8) und mit einer Trägerstruktur (6) des Innenverkleidungsteils in einem einheitlichen Prozessschritt durch Erwärmen in einer Formschale (1, 2) erfolgt.

10. Verfahren nach Anspruch 9, bei dem die in die Formschale (1, 2) eingebrachten Schichten (6-9) mit Ausnahme evtl. Zentrierlaschen einen endformnahen Zuschnitt haben, der in die Formschale (1, 2) passt.

11. Verfahren nach einem der Ansprüche 1 - 7, bei dem die Sperrschicht (13, 17) mit der Metallstruktur (12, 15) verbunden wird und auf einer der Sperrschicht (13, 17) entgegengesetzten Seite der Metallstruktur (12, 15) die weitere Schicht (14, 16, 19) angebracht wird.

12. Verfahren nach Anspruch 11, bei dem das Verbinden der Sperrschicht (13, 17) mit der Metallstruktur (12, 15) und das Vorformen dieses Verbundes in einem einheitlichen Prozessschritt in einer beheizten Formschale erfolgt.

13. Verfahren nach Anspruch 11 oder 12, bei dem die Sperrschicht nach dem Anbringen der Trägerstruktur abgelöst wird und auf derselben Seite der Metallstruktur noch eine weitere Schicht angebracht wird.

14. Verfahren nach Anspruch 11 oder 12, bei dem eine Dekorschicht (17) als Sperrschicht mit der Metallstruktur (12) verbunden wird und auf der der Dekorschicht (17) entgegengesetzten Seite der Metallstruktur (12) eine transparente Schicht (19) angespritzt oder angegossen wird.

15. Verfahren nach einem der vorstehenden Ansprüche, bei dem sich die Metallstruktur (15) über einen Teil der flächigen Ausdehnung des Innenverkleidungsteils erstreckt.

16. Verfahren nach einem der vorstehenden Ansprüche, bei dem sich die Sperrschicht über einen Teil der flächigen Ausdehnung des Innenverkleidungsteils erstreckt.

## Claims

1. A method for producing a vehicle inner covering part
in which method a two-dimensional metal structure (9, 12, 15) being permeable for fluids transversely
is connected with a barrier layer (8, 13, 17)
and is connected with a further layer (7a, 14, 16, 19),
wherein said barrier layer (8, 13, 17) limits a penetration of said further layer (7a, 14, 16, 19) through said metal structure (9, 12, 15), **characterized in that** after the production of said inner covering part said metal structure (9, 12, 15) is at least partially transparent and a layer (7, 14, 16, 17) arranged below said metal structure (9, 12, 15) is visible through said metal structure (9, 12, 15).

2. A method according to claim 1, in which said metal structure (9, 12, 15) is a wire structure, especially a wire mesh.

3. A method according to one of the preceding claims, in which said metal structure (9, 12, 15) as such is at least partially visible as a decoration element after the production of said inner covering part.

4. A method according to one of the preceding claims, in which a carrier structure (14, 16, 18) of said inner covering part is injection-moulded thereon or casted thereon.

5. A method according to claim 4, in which said barrier layer (13) limits the penetration of carrier structure material (14, 16) through said metal structure (12, 15).

6. A method according to one of the preceding claims, in which the connection between said metal structure (9, 12, 15) and said barrier layer (8, 13) is realized by means of softening said barrier layer (8, 13) and at least partial pressing of said barrier layer (8, 13) into said metal structure (9, 12, 15).

7. A method according to claim 6, in which said barrier layer (8, 13) is produced from a polyamide foil.

8. A method according to one of the preceding claims, in which said barrier layer (8) is glued to a further layer (7), preferably by a dry adhesive foil (7a).

9. A method according to one of the preceding claims, in which said connection of said metal structure (9) with said barrier layer (8) and said carrier structure (6) of said inner covering part is realized by one integral process step by heating in a mould (1, 2).

10. A method according to claim 9, in which the layers (6-9) introduced in said mould (1, 2) have a cut-to-size form close to the final form fitting into said mould (1, 2) with the exception of optional centering tongues.

11. A method according to one of claims 1 to 7, in which said barrier layer (13, 17) is connected of said metal structure (12, 15) and said further layer (14, 16, 19) is applied onto the face of said metal structure (12, 15) opposite to said barrier layer (13, 17).

12. A method according to claim 11, in which said connection of said barrier layer (13, 17) to said metal structure (12, 15) and a pre-forming of this compound are realized in one integral process step in a heated mould.

13. A method according claim 11 or 12, in which said barrier layer is removed after the application of the carrier structure and a further layer is applied onto the same side of the metal structure.

14. A method according to claim 11 or 12, in which a decoration layer (17) is connected to said metal structure (12) as said barrier layer and a transparent layer (19) is injection-moulded onto or casted onto the side of said metal structure (12) opposite to said decoration layer (17).

15. A method according to one of the preceding claims, in which said metal structure (15) extends over a part of the planar extension of said inner covering part.

16. A method according to one of the preceding claims, in which said barrier layer extends over a part of the planar extension of said inner covering part.

## Revendications

1. Procédé pour la fabrication d'un élément d'habillage intérieur de véhicule automobile, avec lequel procédé une structure métallique en nappe (9, 12, 15), laquelle est perméable aux fluides perpendiculairement à sa nappe, est combinée avec une couche de barrage (8, 13, 17) et est combinée avec une autre couche (7a, 14, 16, 19), de sorte que la couche de barrage (8, 13, 17) limite la pénétration de l'autre couche (7a, 14, 16, 19) à travers la structure métallique (9, 12, 15),
**caractérisé en ce que** après la fabrication de l'élément d'habillage intérieur, la structure métallique (9, 12, 15) est au moins partiellement transparente et avec lequel une couche (7, 14, 16, 17) disposée sous la structure métallique (9, 12, 15) est visible à travers la structure métallique (9, 12, 15).

2. Procédé selon la revendication 1, avec lequel la structure métallique (9, 12, 15) est une structure à fil métallique, en particulier une toile métallique.

3. Procédé selon l'une des revendications précédentes, avec lequel la structure métallique (9, 12, 15) en tant que telle, après la fabrication de l'élément d'habillage intérieur, est au moins partiellement visible en tant qu'élément décoratif.

4. Procédé selon l'une des revendications précédentes, avec lequel une structure de support (14, 16, 18) de l'élément d'habillage intérieur est injectée ou moulée dessus.

5. Procédé selon la revendication 4, avec lequel la couche de barrage (13) limite la pénétration du matériau de la structure de support (14, 16) à travers la structure métallique (12, 15).

6. Procédé selon l'une des revendications précédentes, avec lequel la liaison entre la structure métallique (9, 12, 15) et la couche de barrage (8, 13) s'effectue en faisant ramollir la couche de barrage (8, 13) et en pressant au moins partiellement la couche de barrage (8, 13) à l'intérieur de la structure métallique (9, 12, 15).

7. Procédé selon la revendication 6, avec lequel la couche de barrage (8, 13) est fabriquée à partir d'une feuille en polyamide.

8. Procédé selon l'une des revendications précédentes, avec lequel la couche de barrage (8) est collée ensemble avec une autre couche (7), de préférence via une feuille adhésive sèche (7a).

9. Procédé selon l'une des revendications précédentes, avec lequel la liaison de la structure métallique (9) avec la couche de barrage (8) et avec une structure de support (6) de l'élément d'habillage intérieur s'effectue au cours d'une étape de processus intégrale par échauffement dans une coque de moule (1, 2).

10. Procédé selon la revendication 9, avec lequel les couches (6-9) placées dans la coque de moule (1, 2), à l'exception d'éventuelles languettes de centrage, présentent une coupe proche de la forme finale, laquelle est ajustée à la coque de moule (1, 2).

11. Procédé selon l'une des revendications 1-7, avec lequel la couche de barrage (13, 17) est combinée avec la structure métallique (12, 15), et avec lequel l'autre couche (14, 16, 19) est ajoutée sur un des côtés de la structure métallique (12, 15) qui est opposé à la couche de barrage (13, 17).

12. Procédé selon la revendication 11, avec lequel la liaison de la couche de barrage (13, 17) avec la structure métallique (12, 15) et le préformage de cette liaison s'effectuent au cours d'une étape du processus intégrale dans une coque de moule chauffée.

13. Procédé selon les revendications 11 ou 12, avec lequel la couche de barrage est détachée après l'ajout de la structure de support, et avec lequel une autre couche est ajoutée sur le même côté de la structure métallique.

14. Procédé selon les revendications 11 ou 12, avec lequel une couche de décoration (17) est combinée avec la structure métallique (12) en guise de couche de barrage, et avec lequel une couche transparente (19) est injectée ou moulée sur le côté de la structure métallique (12) qui est opposé à la couche de décoration (17).

15. Procédé selon l'une des revendications précédentes, avec lequel la structure métallique (15) s'étend sur une partie de l'étendue en nappe de l'élément d'habillage intérieur.

16. Procédé selon l'une des revendications précédentes, avec lequel la couche de barrage s'étend sur une partie de l'étendue en nappe de l'élément d'habillage intérieur.
